# EUROPEAN PATENT SPECIFICATION

(11) **EP 2 044 163 B1**
(45) Date of publication and mention of the grant of the patent: **25.04.2012**
(21) Application number: 07799694.0
(22) Date of filing: 19.07.2007
(51) Int. Cl.: C09J 133/08, C09J 133/06, C08K 3/08

(54) **ELECTRICALLY CONDUCTIVE PRESSURE SENSITIVE ADHESIVES**
ELEKTRISCH LEITENDE HAFTKLEBSTOFFE
ADHÉSIFS SENSIBLES À LA PRESSION ÉLECTRIQUEMENT CONDUCTEURS

(30) Priority: 24.07.2006 US 820174 P
(43) Date of publication of application: 08.04.2009
(73) Proprietor: 3M Innovative Properties Company, St. Paul, MN 55133-3427 (US)
(72) Inventor: MCCUTCHEON, Jeffrey W., Saint Paul, Minnesota 55133-3427 (US); BRUSS, Jeanne M., Saint Paul, Minnesota 55133-3427 (US); LE, John D., Saint Paul, Minnesota 55133-3427 (US); SAWYER, Jennifer L., Saint Paul, Minnesota 55133-3427 (US)
(74) Representative: Vossius & Partner
(86) International application number: PCT/US2007/073838
(87) International publication number: WO 2008/014169

(56) References cited:
- JP-A- 2000 053 733
- JP-A- 2005 126 593
- US-A- 6 126 865
- US-A1- 2004 127 626
- US-B1- 6 214 460

## Description

### Technical Field

This invention relates to electrically conductive adhesives, including isotropic conductive adhesives, and methods of making and using them.

### Background

It is a common practice in the industry to achieve isotropically conductive pressure sensitive adhesive using conductive scrim or carbon fibers to provide lower electrical resistance in an adhesive resin system.

### Summary

Briefly, the present disclosure provides an electrically conductive adhesive comprising a reaction product of a radiation sensitized solventless acrylic pressure sensitive adhesive precursor comprising an acrylic acid ester of non-tertiary alcohol, the alkyl groups of which have an average of 4 to 14 carbon atoms, and a polar comonomer, and electrically conductive flakes having a density greater than zero and below about five grams per cubic centimeter.

In another aspect, the present disclosure provides a method of making an electrically conductive pressure sensitive adhesive comprising mixing a plurality of electrically conductive flakes having a density greater than zero and below about five grams per cubic centimeter with a radiation sensitized solventless acrylic pressure sensitive adhesive precursor comprising an acrylic acid ester of non-tertiary alcohol, the alkyl groups of which have an average of 4 to 14 carbon atoms, and a polar comonomer, and polymerizing the precursor to form a pressure sensitive adhesive.

It is an advantage of the disclosed adhesives to provide improved z-direction (thickness) conductivity performance while also providing equal or better x-y direction (in the plane of an adhesive film) conductivity across the desired gap length and surface area contact while providing good face-side and back-side adhesion to the desired substrate. In some embodiments, these advantages are retained after environmental aging. In some embodiments, the adhesives disclosed herein function well on smaller footprint pad applications where conductivity is needed from a small pad site (x-y dimensions) when adhered to a pad of the same size or to a pad of a different (typically larger) pad size.

Other features and advantages of the invention will be apparent from the following detailed description and the claims. The above summary of principles of the disclosure is not intended to describe each illustrated embodiment or every implementation of the present disclosure. The detailed description that follows more particularly shows certain preferred embodiments using the principles disclosed herein.

### Detailed Description

All numbers are herein assumed to be modified by the term "about." The recitation of numerical ranges by endpoints includes all numbers subsumed within that range (e.g., 1 to 5 includes 1, 1.5, 2, 2.75, 3, 3.80, 4, and 5).

Provided is an electrically conductive adhesive comprising a reaction product of a radiation sensitized solventless acrylic pressure sensitive adhesive (PSA) precursor comprising an acrylic acid ester of non-tertiary alcohol, the alkyl groups of which have an average of 4 to 14 carbon atoms, and a polar comonomer the polar comonomer being present in an amount of from about 1 to about 50 parts by weight in the acrylic pressure sensitive adhesive precursor, and electrically conductive flakes having a density greater than zero and below about five grams per cubic centimeter (g/cc).

The solventless acrylic pressure sensitive adhesive precursor comprises an acrylic acid ester of non-tertiary alcohol, the alkyl groups of which have an average of about 4 to 14 carbon atoms, and a polar comonomer.

Suitable acrylic acid esters include, for example, isooctyl acrylate, 2-ethylhexyl acrylate, butyl acrylate, n-hexyl acrylate, and stearyl acrylate.

The acrylic acid ester non-tertiary alcohol used in the acrylic pressure sensitive adhesive precursor comprises from about 99 to about 50 parts by weight of the precursor. In some embodiments, this ester comprises below about 98 parts by weight of the precursor. In some embodiments this ester comprises below about 80 parts by weight of the precursor.

The solventless acrylic pressure sensitive adhesive precursor may also comprise multifunctional acrylate monomers. Such multifunctional acrylate monomers include for example glycerol diacrylate, glcerol triacrylate, ethyleneglycol diacrylate, diethyleneglycol diacrylate, triethyleneglycol dimethacrylate, 1,3-propanediol diacrylate, 1,3- propanediol dimethacrylate, hexanediol diacrylate, trimethanol triacrylate, 1,2,4-butanetriol trimethylacrylate, 1,4-cyclohexanediol diacrylate, pentaerythritol triacrylate, pentaerythritol tetraacrylate, pentaerythritol tetramethacrylate, sorbitol hexacrylate, bis[1-(2-acryloxy)]-p-ethoxyphenyl dimethylmethane, bis[1-(3-acryloxy-2-hydroxy)]-p-propoxyphenyl-dimethylmethane, tris-hydroxyethyl isocyanurate trimethacrylate, the bis-methacrylates of polyethylene glycols of molecular weight 200-500, and combinations thereof.

The multifunctional acrylate monomers used in the acrylic pressure sensitive adhesive precursor comprise from about 0.05 to about 1 parts by weight of the precursor.

Suitable polar comonomers include, for example, acrylic acid, methacrylic acid, itaconic acid, certain substituted acrylamides such as N,N dimethylacrylamide, N-vinyl-2-pyrrolidone, N-vinyl caprolactam, tetrahydrofurfuryl acrylate, benzylacrylate, 2-phenoxyethylacrylate, and combinations thereof.

The polar comonomer comprises from about in 1 to about 50 parts by weight of the acrylic pressure sensitive adhesive precursor. In some embodiments, the polar monomer comprises at least about two parts by weight of the precursor. In other embodiments, the polar monomer comprises at least about five parts by weight of the precursor.

The monomers and the proportions thereof are selected to provide a normally tacky and pressure-sensitive adhesive copolymer. Normally this means that the monomer mixture will contain from about 50 to 98 parts by weight of the acrylate-type monomer and 2 to 50 parts of the polar monomer copolymerizable therewith, the sum of these being 100 parts by weight. Of course, more than one acrylate-type monomer and/or more than one polar monomer can be used in a mixture when desired.

The solventless acrylic PSA precursor is sensitized by the addition of any known initiator, for example, thermal and photoinitiators.

Photoinitiators which are useful for polymerizing the precursor include the benzoin ethers (such as benzoin methyl ether or benzoin isopropyl ether), substituted benzoin ethers (such as anisoin methyl ether), substituted acetophenones (such as 2,2-diethoxyacetophenone and 2,2-dimethoxy-2-phenylacetophenone), substituted alphaketols (such as 2-methyl-2-hydroxypropiophenone), and photoactive oximes [such as 1-phenyl-1,1-propanedione-2-(O-ethoxycarbonyl)oxime]. Commercially available photoinitiator's include, for example, the Irgacure® series of initiators available from Ciba Specialty Chemicals. An effective amount of photoinitiator is used, such that the precursor is polymerized upon exposure to the appropriate light source for the desired exposure time. For example, such photoinitiators preferably are used in amount that provides about 0.05 to 5 parts per 100 parts by weight of the total precursor monomers.

Photopolymerization of thin layers of the materials disclosed herein can be carried out in an inert atmosphere, to prevent interference from oxygen. Any known inert atmosphere such as nitrogen, carbon dioxide, helium, or argon is suitable, and a small amount of oxygen still can be tolerated. In some embodiments, a sufficiently inert atmosphere can be achieved by covering a layer of the radiation sensitized mixture with a polymeric film which is transparent to the selected ultraviolet radiation and then irradiating through that film in air. Good polymerization results can be attained using a bank of fluorescent black light lamps. Typically, radiation in the near ultraviolet region in the 300-400 nanometer wavelength range at a rate of irradiation of below about 1000 milliJoules per square centimeter can be used, with particular selection within the skill of the art guided by the photoinitiator selection and the choice of monomers.

Other materials can be blended into the radiation sensitized adhesive precursor mixtures, such as pigments, tackifiers, reinforcing agents, fillers, anti-oxidants etc., which selections and amounts do not interfere with the desired results.

The descriptions of the fillers used herein follow those generally accepted in the art. For example, flakes include shards, wedges, trapezoids, and the like, such that the particles are acicular and non-spherical and have a width and depth much greater than the thickness. Fibers have generally similar width and depth, which dimensions typically are much less than the length. Spherical particles may be regular or irregular and generally have similar length, width, and depth dimensions. Spherical particles generally are used for anisotropically conductive adhesives that have high electrical resistance in the plane while having low electrical resistance through the thickness. The adhesives taught in this disclosure generally have low electrical resistance in all directions; that is, they are conductive through the thickness and in the plane perpendicular to the thickness.

The electrically conductive fillers used in these adhesives generally have a low density core material coated with an electrically conductive material. More particularly, polymeric flakes, glass or ceramic shards, and the like can be used as core particles. In other embodiments, hard particles can be used. Electrically conductive metals, mixtures and alloys thereof, and the like, can be used on the surface of the particles, providing low electrical resistance while also having low density. However, solid metals in numerous shapes, such as silver flakes have a density too high for these adhesives, generally because they settle through the adhesive thickness too quickly during manufacture while the low density electrically conductive flakes useful in these adhesives remain suspended for a substantially uniform distribution at least until the adhesive is cured into a stable pressure sensitive adhesive film. Of course, as manufacturing and/or adhesive curing is accelerated, higher density materials can be used while maintaining sufficient distribution through the adhesive thickness for the intended purpose of the resulting adhesive.

The electrically conductive fillers used may be low density electrically conductive fillers, such as carbon flakes or fibers, or fillers of low density material such as polyethylene, polystyrene, phenol resin, epoxy resin, acryl resin, glass particles, glass shards, silica, graphite, or ceramic, prepared with a surface covering or coating of a metal such as silver, copper, nickel, gold, tin, zinc, platinum, palladium, iron, tungsten, molybdenum, alloys thereof, solder, or the like. The conductive coating on the filler may comprise from about 5 to about 45 weight percent (wt. %) of the total weight of the coating plus the base particle. The electrically conductive fillers used also may be particles having a hard and/or sharp core, hard enough or sharp enough to penetrate an oxide or other surface layer on the intended substrate to improve electrical conductivity. For example, steel or stainless steel particles can be used. Coatings with conductivity greater than the core particle also can be used on otherwise conductive core particles.

In some embodiments, the ratio of the density of the electrically conductive particles to the density of the base pressure sensitive adhesive resin is below about 5. For example, the pressure sensitive adhesive resin density may range around from around 0.98 to about 1.1, and electrically conductive particles with a low density base particle having a conductive coating generally have a density below about 5 grams per cubic centimeter (g/cc). In contrast, known electrically conductive metal particles have a density of at least about 7 g/cc.

The amount of electrically conductive filler, which includes flakes and may also include other filler types that are described as fibers or other particles, is sufficient to provide the desired level of electrical resistance while maintaining the desired level of adhesion. If the amount of conductive filler is too high, electrical resistance may be very low, but the adhesion level may be too low. Generally an amount of flakes (in volume percent or vol. %) used in the adhesive is at least about 5, 10, 20, 30 or even greater. In other embodiments, the amount of flakes (vol. %) used in the adhesive ranges below about 35, 30, 25, 20, or even below about 10. In addition to the flakes, other electrically conductive fibers or other particles can be used. In other embodiments, the amount of other conductive particles (weight percent or wt. %) used in the adhesive is below about 50, 40, 35, or even lower and in vol. % below about 10, 7, 5, or even lower. Generally the total amount of electrically conductive filler (vol. %) is below about 35, 30, or even below about 25.

The electrical resistance of the adhesives disclosed is generally below about 4 Ohms as measured through the thickness (also called the "z-direction"), while also being below about 5 Ohms as measured in the plane. As used herein, the plane of the adhesive is the x-y direction or that direction perpendicular to the adhesive thickness. In some embodiments, the electrical resistance (Ohms) in the z-direction is below about 4, 3, 2, or even below about 0.5. In some embodiments, the electrical resistance (Ohms) in the x-y direction is below about 5, 4, 3, 2, or even below about 0.5.

The peel adhesion level of the adhesives disclosed (in N/cm) is generally at least about 3, 3.5, 4, or even higher. In some embodiments, the peel adhesion level of the adhesives disclosed is balanced such that the adhesion on one surface of a disclosed film is within about 20% of the adhesion value of the opposing surface. In some embodiments, this adhesion balance is within about 10%, or even closer to evenly balanced between the opposing surfaces.

The adhesives of the present disclosure may have any suitable thickness. For example, a thickness (in micrometers or µm) of at least about 20, 30, or even greater thickness can be used. In other embodiments, the adhesive has a thickness (µm) below about 200, below about 80, below about 70, below about 60, or even thinner.

In another aspect, the present disclosure provides a method of making an electrically conductive pressure sensitive adhesive. Generally, these adhesives can be made by mixing a plurality of electrically conductive flakes having a density greater than zero and below about five grams per cubic centimeter with a radiation sensitized solventless acrylic pressure sensitive adhesive precursor comprising an acrylic acid ester of non-tertiary alcohol, the alkyl groups of which have an average of about 4 to 14 carbon atoms, and a polar comonomer, and polymerizing the precursor to form a pressure sensitive adhesive. Useful materials include those disclosed above.

Such mixtures also can be coated, using any known means, onto a flexible tape backing or release liner. Such tape backings and release liners are well known in the adhesive arts. Particular selection is within the skill of the art.

Generally, the mixtures of these electrically conductive adhesive materials keep the electrically conductive flakes suspended in the flakes-precursor mixture. Preferably, the precursors are polymerized while the flakes are suspended, providing flakes substantially uniformly suspended through the thickness of the coating. In one embodiment, the precursors are polymerized while the other conductive particles are substantially suspended, providing particles substantially uniformly suspended through the thickness of the coating. "Substantially uniformly suspended" means that particles are located throughout the adhesive thickness such that below about 80%, 70%, 60%, or even fewer, of the particles are found below a midline through the adhesive thickness. In the opposite situation, more than 80% or even substantially all the particles settle to the bottom of the adhesive.

In some embodiments, the mixture contains sufficient electrically conductive flakes to provide an adhesive having an electrical resistance below about four ohms measured through the thickness. This amount of flakes (in volume percent or vol. %) used in the adhesive typically ranges from about 5 up to about 30, as described above.

The new isotropic adhesives of some aspects of this disclosure also can provide improved thermal conductivity as compared to known scrim-based isotropic adhesive products. Such embodiments can be useful in situations where thermal conductivity is desired together with electrical conductivity. Examples include devices requiring a uniform heat profile and/or heat-generating devices needing to release heat.

In some embodiments, the adhesives of the present disclosure can be used in grounding applications, for example, in electromagnetic interference (EMI) shielding in a communication device such as a cell phone. In other aspects the adhesives of the present disclosure can be used with printed circuit boards (PCB), printed wire boards (PWB), or flexible circuitry (also called "flex"). In one example, a ground pad of about 4 to about 20 square millimeters can be grounded to a larger EMI shielding material, that may be in the range of 10 mm x 25 mm or even larger, with the connection being provided with an adhesive according to the present disclosure. Know materials for such uses are limited by shield designs with valleys or recessions that are bridged, reducing effectiveness. In such situations, the valley dimensions can be accommodated with the electrically conductive adhesives of this disclosure in embodiments where the electrically conductive pressure sensitive adhesive conforms to the surface through peaks and valleys across various circuit features.

In some embodiments, the provided adhesives maintain low electrical resistance after several days to at least about four weeks cycling between a low temperature of -40°C to a high temperature of 85°C. In some embodiments, the provided adhesives maintain low electrical resistance after several days to at least about four weeks accelerated aging at 60°C in 90% relative humidity. In some embodiments, the provided adhesives maintain low electrical resistance after several days to at least about four weeks accelerated aging at 70°C in ambient relative humidity.

In some embodiments, the provided adhesives also provide thermally conductive benefits along with their low electrical resistance. For example, an acrylic pressure sensitive adhesive without conductive fillers may have a conductivity of about 0.18 W/mK. 3M™ 8805 High Adhesion Thermally Conductive Adhesive Transfer Tape (from 3M Company, St. Paul, MN) is reported to have a thermal conductivity of 0.60 W/mK. In some embodiments, the adhesives disclosed herein have a thermal conductivity from about 0.50 W/mK up to about 1.8 W/mK.

Objects and advantages of this invention are further illustrated by the following examples, but the particular materials and amounts thereof recited in these examples, as well as other conditions and details, should not be construed to unduly limit this invention.

### Examples

Where not otherwise specified, materials were available from chemical supply houses, such as Aldrich, Milwaukee, WI. Amounts are in parts by weight unless otherwise indicated.

### Materials

| Material Resignation | Source | Description |
|---|---|---|
| Conduct-o-Fil® SF82TF8 | Potters Industries Inc., (Valley Forge, PA) (Potters) | Silver coated glass fibers (weight % silver > 7, Fiber length, D10 = > 15 µm, D50 = 30-80 µm, and D90 = < 150 µm ) |
| Conduct-o-Fil® SF82TF20 | Potters | Silver coated glass fibers (weight % silver >17, Fiber length, D50 = 30-80 µm) |
| Conduct-o-Fil® SG15F35 | Potters | Silver coated glass flakes (35 weight % silver, D10 = 8 µm, D50 = 19 µm, D90 = 32 µm) |
| Conduct-o-Fil® S-3000-S3N | Potters | Silver coated glass spheres |
| Novamet 7181 | Novamet Specialty Products, (Wycoff, NJ) (Novamet) | Silver coated Nickel particle agglomerate |
| Novamet HCA-1 | Novamet | Nickel Flake |
| Novamet CHT 05300-1 | Novamet | Silver Coated Nickel Flake |
| Ciba® Irgacure® 651 | Ciba Specialty Chemicals, (Tarrytown, NY) | 2,2-dimethoxy-2-phenyl-acetophenone |

### Test Methods

### Conductivity Test

The IPC Multi-Purpose test board (IPC-B-25A) (Diversified Systems, Inc., Indianapolis, IN) is used to measure the conductivity of the adhesive in both the z-direction and the conductivity in the x-y plane. The z-axis is the axis along the thickness of the adhesive. To measure the conductivity in the x-y plane of the adhesive, the adhesive was laminated to 1.7 mil (43 µm) thick Kapton® polyimide film (DuPont, Wilmington, DE). A test sample 2 mm wide and approximately 25 mm long was cut from the laminate. The test sample was laminated to the IPC-B-25A test board across the set of traces that were 2.0 mm apart. The test samples was laminated with light (0.35 kilograms/cm²) finger pressure. The test assembly was allowed to remain at 23°C for one hour. The electrical resistance between two traces that were separated by a 2 mm gap was measured with a multimeter resistance probe. For measuring the conductivity in the z-axis direction (thickness), the adhesive sample was laminated over a portion of a 2.7 millimeter wide, gold plated copper trace on a polyimide film. A portion of the gold plated copper trace was not covered by the adhesive. The polyimide test strip was laminated over the 2.1 mm wide traces on the IPC-B-25 test board. This defined a 2.1 mm by 2.7 mm overlap junction between the gold plated copper strip covered with the adhesive test sample and the two mm wide trace on the IPC-B-25 circuit board. The portion of the gold plated copper trace that was not covered with adhesive was clamped in contact with one of the traces on the IPC board that was not covered by the adhesive test sample. The resistance was measured by probing the IPC trace that was in contact with the adhesive and the IPC trace that was in contact with the gold plated copper trace on the polyimide film.

### Peel Force Test

An adhesive film sample was laminated, with a one inch rubber roller and hand pressure of about 0.35 kilograms per square centimeter, to a 45 µm thick polyethylene terephthalate (PET) film. A one inch (25.4 cm) wide strip was cut from the adhesive film/PET laminate. This adhesive film side of the test strip was laminated, with a two kilogram rubber roller, to a stainless steel plate which had been cleaned by wiping it once with acetone and three times with heptane. The laminated test sample was allowed to remain at ambient conditions for one hour. The adhesive film sample/PET test sample was removed from the stainless steel surface at an angle of 180 degrees at a rate of 30.5 centimeters per minute. The force was measured with an Imass Model SP-2000 (Imass Inc., Accord, VA) tester.

### Adhesive Film Preparation

### Adhesive Syrup 1

A mixture of 98 parts of isooctyl acrylate, 2 parts of acrylic acid and 0.04 parts of the photoinitator, Ciba® Irgacure® 651, was partially photopolymerized using fluorescent black light lamps to a syrup having a viscosity of about 1000 centipoises (1 N*s/m²).

### Adhesive Syrup 2

A mixture of 74.7 parts of isooctyl acrylate, 24.9 parts of N-vinyl-caprolactam (ISP Technologies, Wayne, NJ), and 0.23 parts of the photoinitiator, Ciba® Irgacure® 651 was partially photopolymerized using fluorescent black light lamps to a syrup having a viscosity of about 2000 centipoises (2 N*s/m²).

### Example 1

A mixture of 63 g of Adhesive Syrup 1 and 250 g of Adhesive Syrup 2 were blended with 66.9 g of conductive fibers (Conduct-o-Fil® SF82TF8), 115.8 g of conductive flakes (Conduct-o-Fil® SG15F35) and 0.09 grams of hexanediol diacrylate (HDDA) (Cytec Industries Inc., West Paterson, NJ). The mixture was degassed under reduced pressure and immediately coated between two silicone treated transparent plastic films to a thickness of approximately 51 µm. The coating was irradiated in an inert atmosphere, with fluorescent black light lamps such that the energy received at the surface of the adhesive coating was 940 milliJoules (mJ)/cm². The irradiation energy received at the adhesive coating surface was calibrated using a Light Mapper UVI Map available from Electronic Instrumentation and Technology, Inc., Sterling, VA. Examples 2-7 were made substantially as described in Example 1 with the amounts varying as shown in Table 1 and the energy varying as shown in Table 2. Test results are shown in Table 2.

### Comparative Example C1

3M™ 9713 XYZ-Axis Electrically Conductive Tape, a high performance pressure sensitive adhesive loaded with conductive fibers, from 3M Company, Saint Paul, MN.

### Comparative Example C2

Comparative Example C2 was prepared by the same procedure as Example 1, except that 45 g of Adhesive Syrup 1, 182 g of Adhesive Syrup 2, 0.07 g of HDDA and 227 grams of Conduct-o-Fil® S-3000-S3N were used to make the adhesive coating solution. The irradiation energy received at the adhesive coating surface was 659 mJ/cm².

### Comparative Example C3

Comparative Example C3 was prepared by the same procedure as Example 1, except that 227 g of Adhesive Syrup 1, 0.34 g of HDDA, 153.2 g of Conduct-o-Fil® SF82TF20 and 122.2 g of Novamet 7181 were used to make the adhesive coating solution. The irradiation energy received at the adhesive coating surface was 940 mJ/cm².

### Comparative Example C4

Comparative Example C4 was prepared by the same procedure as Example 1, except that 45 g of Adhesive Syrup 1, 182.0 grams of Adhesive Syrup 2, 0.07 g of HDDA, 48.5 g (6.3 vol. %) of Conduct-o-Fil® SF82TF8 116.9 g (11.6 vol. %) of Conduct-o-Fil® SG15F35 and 48.5 g (6.1 vol. %) g of Conduct-o-Fil® S-3000-S3N were used to make the adhesive coating solution. The irradiation energy received at the adhesive coating surface was 659 mJ/cm².

**Table 1. Adhesive Compositions**

| | | | | **Fillers (Grams/ Volume %)** | | |
|---|---|---|---|---|---|---|
| **Example** | **Adhesive Syrup 1 (grams)** | **Adhesive Syrup 2 (grams)** | **HDDA (grams)** | **SF82TF8** | **SF82TF20** | **SG15F35** |
| 1 | 63 | 250 | 0.09 | 66.9/6.9 | - | 115.8/9.2 |
| 2 | 63 | 250 | 0.09 | 66.9/6.7 | - | 161.2/12.4 |
| 3 | 63 | 250 | 0.09 | 66.9/6.5 | - | 212.2/15.6 |
| 4 | 364 | 1453 | 0.55 | 388.1/6.5 | - | 1231.7/15.6 |
| 5 | 364 | 1453 | 0.55 | - | - | 1817/23.0 |
| 6 | 364 | 1453 | 0.55 | - | 388.1/ 15.7 | 1817/6.0 |
| 7 | 45 | 182 | 0.07 | - | - | 154/20.7* |

| | | | | | | |
|---|---|---|---|---|---|---|
| * Example 7 also contained 122 g (5.7 vol. %) ofNovamet 7181 filler particles. | | | | | | |

**Table 2. Curing Energy and Test Results**

| **Example** | **Irradiation Energy (mJ/cm²)** | **Z-Axis Resistivity (2 mm x 2 mm) (Ohms)** | **XY -Plane Resistivity (2mm gap, 5 mm wide) (Ohms)** | **Peel Force (N/cm) Side A** | **Peel Force (N/cm) Side B** |
|---|---|---|---|---|---|
| 1 | 940 | 2.9 | 3.35 | 4.2 | 4.6 |
| 2 | 940 | 0.37 | 3.35 | 4.6 | 4.5 |
| 3 | 940 | 0.17 | 1 | 4.7 | 4.3 |
| 4 | 842 | 0.19 | 1.09 | 4.5 | 4.4 |
| 5 | 842 | 0.11 | 0.45 | 3.5 | 3.8 |
| 6 | 842 | 0.19 | 0.86 | 3.8 | 4.0 |
| 7 | 560 | 0.10 | 1.67 | 3.5 | 3.7 |
| C1 | - | 4.61 | 7.33 | 3.4 | 4.0 |
| C2 | 659 | 0.16 | Open | 5.9 | 5.9 |
| C3 | 940 | 0.07 | Open | 1.4 | 1.4 |
| C4 | 659 | 0.29 | 1.2 | 2.8 | 2.7 |

Foreseeable modifications and alterations of this invention will be apparent to those skilled in the art without departing from the scope and spirit of this invention. This invention should not be restricted to the embodiments that are set forth in this application for illustrative purposes. All publications and patents are herein incorporated by reference to the same extent as if each individual publication or patent was specifically and individually indicated to be incorporated by reference.

## Claims

1. An electrically conductive adhesive comprising:
a reaction product of a radiation sensitized solventless acrylic pressure sensitive adhesive precursor comprising an acrylic acid ester of non-tertiary alcohol, the alkyl groups of which have an average of 4 to 14 carbon atoms, and a polar comonomer, the polar comonomer being present in an amount of from about 1 to about 50 parts by weight in the acrylic pressure sensitive adhesive precursor; and
electrically conductive flakes having a density greater than zero and below about five grams per cubic centimeter.

2. The adhesive of claim 1 wherein the electrically conductive flakes comprise from about 5 to about 35 volume percent of the adhesive composition.

3. The adhesive of claim 1 wherein the polar comonomer is selected from acrylic acid, itaconic acid, N,N-dimethylacrylamide, N-vinyl-2-pyrrolidone, N-vinyl caprolactam, acrylonitrile, tetrahydrofurfuryl acrylate, 2-phenoxyethylacrylate, and benzylacrylate, acrylic acid, and combinations thereof.

4. The adhesive of claim 1 further comprising at least one of electrically conductive particles and electrically conductive fibers.

5. The adhesive of claim 4 wherein electrically conductive fibers have a density greater than zero and below about five grams per cubic centimeter.

6. The adhesive of claim 1 wherein the flakes comprise from about 5 to about 25 volume percent of the adhesive composition.

7. A film comprising the adhesive of claim 1 having a thickness from about 20 to about 200 micrometers.

8. The film of claim 7 wherein the flakes are substantially uniformly distributed through the thickness of the film.

9. The film of claim 7 wherein the adhesive has an electrical resistance below about four ohms measured in through the thickness.

10. The film of claim 7 wherein the adhesive has an electrical resistance below about two ohms measured in the plane perpendicular to the thickness.

11. The film of claim 7 wherein the adhesive has a peel adhesion of at least about 3 N/cm.

12. A method of making an electrically conductive pressure-sensitive adhesive comprising:
mixing a plurality of electrically conductive flakes having a density greater than zero and below about five grams per cubic centimeter with a radiation sensitized solventless acrylic pressure sensitive adhesive precursor comprising an acrylic acid ester of non-tertiary alcohol, the alkyl groups of which have an average of 4 to 14 carbon atoms, and a polar comonomer, the polar comonomer being present in an amount of from about to about 50 parts by weight of the acrylic pressure sensitive adhesive precursor; and
polymerizing the precursor to form a pressure sensitive adhesive.

13. The method of claim 12 further comprising coating the mixture onto a flexible tape backing or release liner.

14. The method of claim 13 wherein mixing the precursor suspends the flakes in the mixture.

15. The method of claim 13 wherein the mixture is polymerized while the flakes are suspended through the thickness of the coating.

16. The method of claim 13 wherein the mixture contains sufficient electrically conductive flakes to provide an adhesive having an electrical resistance below about four ohms measured in through the thickness.

17. The method of claim 12 wherein the polar comonomer is selected from acrylic acid, itaconic acid, N,N-dimethylacrylamide, N-vinyl-2-pyrrolidone, N-vinyl caprolactam, acrylonitrile, tetrahydrofurfuryl acrylate, 2-phenoxyethylacrylate, and benzylacrylate, acrylic acid, and combinations thereof.

## Patentansprüche

1. Elektrisch leitfähiger Klebstoff, umfassend:
ein Umsetzungsprodukt eines strahlungssensibilisierten lösungsmittelfreien Acrylhaftklebstoffvorläufers, umfassend einen Acrylsäureester von nichttertiärem Alkohol, dessen Alkylgruppen durchschnittlich 4 bis 14 Kohlenstoffatome aufweisen, und ein polares Comonomer, wobei das polare Comonomer in dem Acrylhaftklebstoffvorläufer in einer Menge von etwa 1 bis etwa 50 Gewichtsteilen vorliegt; und
elektrisch leitfähige Flakes mit einer Dichte von mehr als null und unter etwa fünf Gramm pro Kubikzentimeter.

2. Klebstoff nach Anspruch 1, wobei die elektrisch leitfähigen Flakes etwa 5 bis etwa 35 Volumenprozent der Klebstoffzusammensetzung umfassen.

3. Klebstoff nach Anspruch 1, wobei das polare Comonomer aus Acrylsäure, Itaconsäure, N,N-Dimethylacrylamid, N-Vinyl-2-pyrrolidon, N-Vinylcaprolactam, Acrylnitril, Tetrahydrofurfurylacrylat, 2-Phenoxyethylacrylat und Benzylacrylat, Acrylsäure und Kombinationen davon ausgewählt ist.

4. Klebstoff nach Anspruch 1, der ferner elektrisch leitfähige Teilchen und/oder elektrisch leitfähige Fasern umfasst.

5. Klebstoff nach Anspruch 4, wobei die elektrisch leitfähigen Fasern eine Dichte von mehr als null und unter etwa fünf Gramm pro Kubikzentimeter aufweisen.

6. Klebstoff nach Anspruch 1, wobei die Flakes etwa 5 bis etwa 25 Volumenprozent der Klebstoffzusammensetzung umfassen.

7. Film, umfassend den Klebstoff nach Anspruch 1 mit einer Dicke von etwa 20 bis etwa 200 Mikrometer.

8. Film nach Anspruch 7, wobei die Flakes im Wesentlichen einheitlich über die Dicke des Films verteilt sind.

9. Film nach Anspruch 7, wobei der Klebstoff einen durch die Dicke gemessenen elektrischen Widerstand unter etwa vier Ohm aufweist.

10. Film nach Anspruch 7, wobei der Klebstoff einen in der zur Dicke senkrechten Ebene gemessenen elektrischen Widerstand unter etwa zwei Ohm aufweist.

11. Film nach Anspruch 7, wobei der Klebstoff eine Schälhaftung von mindestens etwa 3 N/cm aufweist.

12. Verfahren zur Herstellung eines elektrisch leitfähigen Haftklebstoffs, umfassend:
Mischen mehrerer elektrisch leitfähiger Flakes mit einer Dichte von mehr als null und unter etwa fünf Gramm pro Kubikzentimeter mit einem strahlungssensibilisierten lösungsmittelfreien Acrylhaftklebstoffvorläufer, umfassend einen Acrylsäureester von nichttertiärem Alkohol, dessen Alkylgruppen durchschnittlich 4 bis 14 Kohlenstoffatome aufweisen, und ein polares Comonomer, wobei das polare Comonomer in einer Menge von etwa 1 bis etwa 50 Gewichtsteilen, bezogen auf den Acrylhaftklebstoff vorläufer, vorliegt; und
Polymerisieren des Vorläufers zu einem Haftklebstoff.

13. Verfahren nach Anspruch 12, ferner umfassend das Auftragen der Mischung auf einen flexiblen Bandträger oder Releaseliner.

14. Verfahren nach Anspruch 13, bei dem durch das Mischen des Vorläufers die Flakes in der Mischung suspendiert werden.

15. Verfahren nach Anspruch 13, bei dem die Mischung polymerisiert wird, während die Flakes über die Dicke der Beschichtung suspendiert sind.

16. Verfahren nach Anspruch 13, bei dem die Mischung ausreichend elektrisch leitfähige Flakes zur Bereitstellung eines Klebstoffs mit einem durch die Dicke gemessenen elektrischen Widerstand unter etwa vier Ohm enthält.

17. Verfahren nach Anspruch 12, bei dem man das polare Comonomer aus Acrylsäure, Itaconsäure, N,N-Dimethylacrylamid, N-Vinyl-2-pyrrolidon, N-Vinylcaprolactam, Acrylnitril, Tetrahydrofurfurylacrylat, 2-Phenoxyethylacrylat und Benzylacrylat, Acrylsäure und Kombinationen davon auswählt.

## Revendications

1. Adhésif électriquement conducteur comprenant :
un produit de réaction d'un précurseur d'adhésif acrylique sensible à la pression sans solvant sensibilisé par rayonnement comprenant un ester d'acide acrylique d'alcool non tertiaire dont les groupes alkyle portent en moyenne 4 à 14 atomes de carbone et un comonomère polaire, le comonomère polaire étant présent en une quantité d'environ 1 à environ 50 parties en poids dans le précurseur d'adhésif acrylique sensible à la pression ; et
des paillettes électriquement conductrices ayant une densité supérieure à zéro et inférieure à environ cinq grammes par centimètre cube.

2. Adhésif selon la revendication 1 dans lequel les paillettes électriquement conductrices représentent environ 5 à environ 35 pour cent en volume de la composition adhésive.

3. Adhésif selon la revendication 1 dans lequel le comonomère polaire est choisi parmi l'acide acrylique, l'acide itaconique, le N,N-diméthylacrylamide, la N-vinyl-2-pyrrolidone, le N-vinylcaprolactame, l'acrylonitrile, l'acrylate de tétrahydrofurfiuyle, l'acrylate de 2-phénoxyéthyle, et l'acrylate de benzyle, l'acide acrylique, et les combinaisons de ceux-ci.

4. Adhésif selon la revendication 1 comprenant en outre des particules électriquement conductrices et/ou des fibres électriquement conductrices.

5. Adhésif selon la revendication 4 dans lequel les fibres électriquement conductrices ont une densité supérieure à zéro et inférieure à environ cinq grammes par centimètre cube.

6. Adhésif selon la revendication 1 dans lequel les paillettes représentent environ 5 à environ 25 pour cent en volume de la composition adhésive.

7. Film comprenant l'adhésif selon la revendication 1 ayant une épaisseur d'environ 20 à environ 200 micromètres.

8. Film selon la revendication 7 dans lequel les paillettes sont distribuées de façon sensiblement uniforme à travers l'épaisseur du film.

9. Film selon la revendication 7 dans lequel l'adhésif a une résistance électrique inférieure à environ quatre ohms, mesurée à travers l'épaisseur.

10. Film selon la revendication 7 dans lequel l'adhésif a une résistance électrique inférieure à environ deux ohms, mesurée dans le plan perpendiculaire à l'épaisseur.

11. Film selon la revendication 7 dans lequel l'adhésif a une adhérence au décollement d'au moins environ 3 N/cm.

12. Procédé de fabrication d'un adhésif sensible à la pression électriquement conducteur comprenant :
le mélange d'une pluralité de paillettes électriquement conductrices ayant une densité supérieure à zéro et inférieure à environ cinq grammes par centimètre cube avec un précurseur d'adhésif acrylique sensible à la pression sans solvant sensibilisé par rayonnement comprenant un ester d'acide acrylique d'alcool non tertiaire dont les groupes alkyle portent en moyenne 4 à 14 atomes de carbone et un comonomère polaire, le comonomère polaire étant présent en une quantité d'environ 1 à environ 50 parties en poids du précurseur d'adhésif acrylique sensible à la pression ; et
la polymérisation du précurseur pour former un adhésif sensible à la pression.

13. Procédé selon la revendication 12 comprenant en outre le dépôt du mélange sur un support de ruban flexible ou une doublure détachable.

14. Procédé selon la revendication 13 dans lequel le mélange du précurseur met les paillettes en suspension dans le mélange.

15. Procédé selon la revendication 13 dans lequel le mélange est polymérisé pendant que les paillettes sont mises en suspension à travers l'épaisseur du revêtement.

16. Procédé selon la revendication 13 dans lequel le mélange contient suffisamment de paillettes électriquement conductrices pour obtenir un adhésif ayant une résistance électrique inférieure à environ quatre ohms, mesurée à travers l'épaisseur.

17. Procédé selon la revendication 12 dans lequel le comonomère polaire est choisi parmi l'acide acrylique, l'acide itaconique, le N,N-diméthylacrylamide, la N-vinyl-2-pyrrolidone, le N-vinylcaprolactame, l'acrylonitrile, l'acrylate de tétrahydrofurfuryle, l'acrylate de 2-phénoxyéthyle, et l'acrylate de benzyle, l'acide acrylique, et les combinaisons de ceux-ci.
